# EUROPEAN PATENT APPLICATION

(11) **EP 3 252 581 A1**
(43) Date of publication of application: **06.12.2017**
(21) Application number: 16889664.5
(22) Date of filing: 01.04.2016
(51) Int. Cl.: G06F 3/044

(54) **INTEGRATOR CIRCUIT AND SIGNAL PROCESSING MODULE**

(71) Applicant: Shenzhen Goodix Technology Co., Ltd., Futian Free Trade Zone Shenzhen, Guangdong 518000 (CN)
(72) Inventor: YANG, Fuchiang, Shenzhen Guangdong 518000 (CN); WEN, Yanan, Shenzhen Guangdong 518000 (CN); LIANG, Yingsi, Shenzhen Guangdong 518000 (CN)
(74) Representative: Straus, Alexander
(86) International application number: PCT/CN2016/078308
(87) International publication number: WO 2017/166286

(57) **Abstract**

The present invention provides an integrating circuit and a signal processing module. The integrating circuit comprises an operational amplifier; an integrating capacitor, coupled to an output terminal and a first input terminal of the operational amplifier; and an adjustable resistance module, coupled between the first input terminal of the operational amplifier and an integrating input terminal of the integrating circuit. The adjustable resistance module receives a plurality of first control signals, to adjust a resistance value of the adjustable resistance module. The present invention may realize the noise brought by sidelobe to enhance the SNR, and reduce the power consumption and complexity of the overall circuit.

## Description

### Technical field

The present invention relates to an integrating circuit and a signal processing module, and more particularly, to an integrating circuit and a signal processing module capable of suppressing sidelobe.

### Background

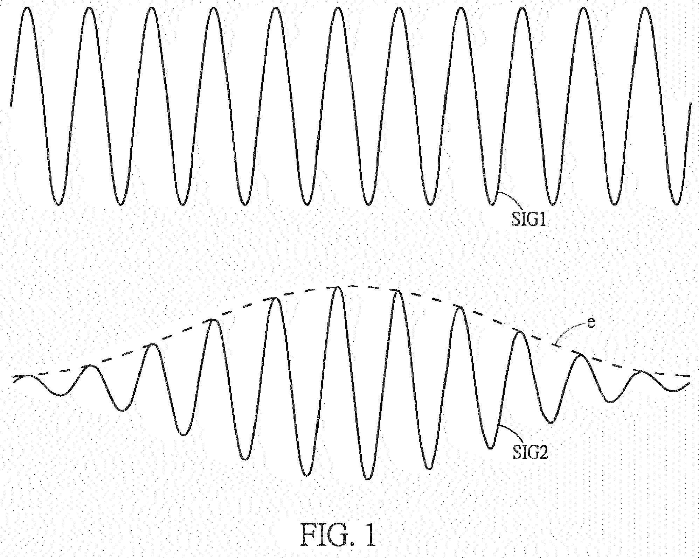

Match Filter and mixer are widely exploited in communication systems and capacitive touch control systems. In general, the mixer may be realized by a multiplier, which generates a multiplication result of a received signal and a local signal. In addition, the mixer may be further realized by a switching mixer with high linearity and low noise. The switching mixer is equivalent to multiplying the received signal by a square wave (i.e., the local signal). However, either the square wave or the sinusoidal wave has sidelobe in frequency domain, and an extra noise is brought in, such that a system SNR (Signal to Noise Ratio) is lowered. In order to solve problem of noise brought by the sidelobe, window function may be applied before the integrator. As FIG. 1 shows, a signal SIG1 represents a waveform without applying any window function, and a signal SIG2 represents a waveform applying a window function e. As can be seen from FIG. 1, the window function e may be regarded as an envelop of the signal SIG2. Applying the window function e may effectively suppress noise brought by sidelobe, and enhance an anti-interference capability around the frequency band, such that the system SNR is enhanced.

The effect of window function may be realized by a digital integrator, where the digital integrator may use different integration gains at different time intervals, to achieve the effect of applying the window function. However, an output frequency of the digital integrator is higher, which is not suitable for the design of the back-end analog-to-digital converter (ADC). In other words, the back-end analog-to-digital converter needs to have sufficient high sampling rate to accurately perform sampling on the output signal of the digital integrator, where the power consumption and complexity of the circuit are raised. Therefore, it is necessary to improve the prior art.

### Summary

It is therefore a primary objective of the present invention to provide an integrating circuit and a signal processing module capable of suppressing sidelobe, to improve over disadvantages of the prior art.

The present invention discloses an integrating circuit. The integrating circuit includes: an operational amplifier; an integrating capacitor, coupled to an output terminal and a first input terminal of the operational amplifier; and an adjustable resistance module, coupled between the first input terminal of the operational amplifier and an integrating input terminal of the integrating circuit. The adjustable resistance module receives a plurality of first control signals, to adjust a resistance value of the adjustable resistance module.

The present invention further discloses an integrating circuit. The integrating circuit includes: an operational amplifier; an integrating capacitor, coupled to an output terminal and a first input terminal of the operational amplifier; and a switched-capacitor module, coupled between the first input terminal of the operational amplifier and the integrating input terminal of the integrating circuit. The switched-capacitor module includes an adjustable capacitance module, receiving a plurality of control signals, to adjust a capacitance value between a first terminal and a second terminal of the adjustable capacitance module; a first switch, coupled to the first terminal of the adjustable capacitance module; a second switch, coupled between the first terminal of the adjustable capacitance module and a ground; a third switch, coupled between the second terminal of the adjustable capacitance module and the first input terminal of the operational amplifier; and a fourth switch, coupled between the second terminal of the adjustable capacitance module and the ground.

The present invention further discloses a signal processing module including a switching mixer; an analog-to-digital converter; an integrating circuit, coupled between the switching mixer and the analog-to-digital converter. The integrating circuit includes an operational amplifier; an integrating capacitor unit, coupled to an output terminal and a first input terminal of the operational amplifier; and an adjustable module, coupled between the first input terminal of the operational amplifier and an integrating input terminal of the integrating circuit. The adjustable module is controlled by a plurality of signals, to adjust a resistance value of a capacitance value of the adjustable module.

The present invention further discloses an integrating circuit. The integrating circuit includes a first operational amplifier; an adjustable integrating capacitor module, coupled between a first input terminal and an output terminal of the first operational amplifier, wherein the adjustable integrating capacitor module includes a plurality of integrating-capacitor-selecting units, and each integrating-capacitor-selecting unit includes an integrating capacitor and at least a switch; and a voltage following module, coupled to the plurality of integrating-capacitor-selecting units of the adjustable integrating capacitor module; wherein the adjustable integrating capacitor module receives a plurality of control signals, to adjust a capacitance value between the first input terminal and the output terminal.

By the integrating circuit provided by the present invention, the adjustable resistance module may be controlled by the control signals, to adjust a resistance value between the first terminal and the second terminal of the adjustable resistance module at different time intervals, so as to change the integration gain of the integrating circuit at the different time intervals; or the adjustable capacitance module may be controlled by the control signals, to adjust a capacitance value between the first terminal and the second terminal of the adjustable capacitance module at different time intervals, so as to change the integration gain of the integrating circuit at the different time intervals. The present invention utilizes analog integrator to realize the effect of window function, which may adjust the integration gain corresponding to different time intervals, reduce noise brought by sidelobe and enhance the SNR. Compared to the prior art, the integrating circuit of the present invention may reduce a requirement of sampling rate of the analog-to-digital converter, such that the power consumption and complexity of the overall circuit are reduced.

### Brief Description of the Drawings

FIG. 1 is a schematic diagram of a plurality of waveforms.
FIG. 2 is a schematic diagram of an integrating circuit according to an embodiment of the present invention.
FIG. 3 is a waveform of an output signal of the integrating circuit of FIG. 1.
FIG. 4 is a schematic diagram of an integrating circuit according to an embodiment of the present invention.
FIG. 5 is a schematic diagram of an integrating circuit according to an embodiment of the present invention.
FIG. 6 is a schematic diagram of an integrating circuit according to an embodiment of the present invention.
FIG. 7 is a schematic diagram of an integrating circuit according to an embodiment of the present invention.
FIG. 8 is a schematic diagram of a switched-capacitor module according to an embodiment of the present invention.
FIG. 9 is a schematic diagram of an integrating circuit according to an embodiment of the present invention.
FIG. 10 is a schematic diagram of a signal processing module according to an embodiment of the present invention.
FIG. 11 is a schematic diagram of an integrating circuit according to an embodiment of the present invention.
FIG. 12 is a schematic diagram of an integrating circuit according to an embodiment of the present invention.

### Detailed Description

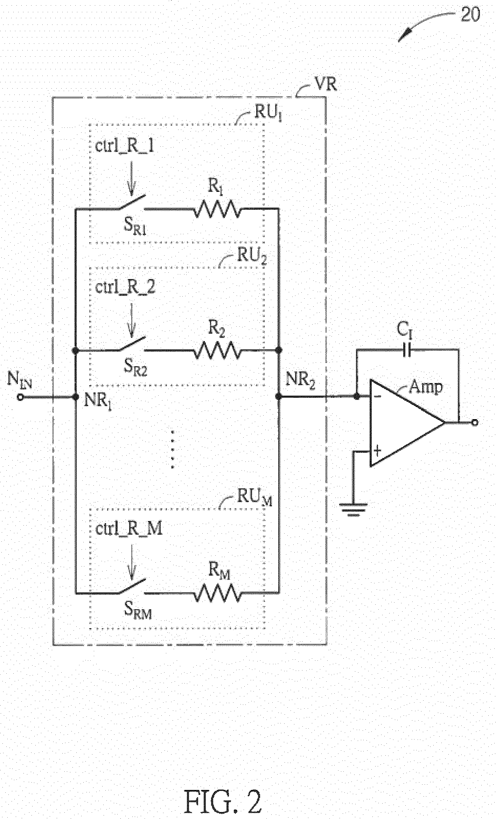

The present invention utilizes an analog integrating circuit to realize an effect of window function, which is able to adjust different integration gains corresponding to different time intervals at the different time intervals. Please refer to FIG. 2. FIG. 2 is a schematic diagram of an integrating circuit 20 according to an embodiment of the present invention. The integrating circuit 20 is a resistor-capacitor (RC) integrator, which includes an operational amplifier Amp, an integrating capacitor C_{I} and an adjustable resistance module VR. The operational amplifier Amp includes a negative input terminal (denoted as "-"), a positive input terminal (denoted as "+") and an output terminal. The integrating capacitor C_{I} is coupled between the negative input terminal and the output terminal of the operational amplifier Amp. The adjustable resistance module VR is coupled between the negative input terminal of the operational amplifier Amp and an integrating input terminal N_{IN} of the integrating circuit 20. The adjustable resistance module VR includes resistor-selecting units RU₁-RU_{M}. The adjustable resistance module VR is formed by the resistor-selecting units RU₁-RU_{M} connected to each other in parallel, wherein any resistor-selecting unit RUₘ of the resistor-selecting units RU₁-RU_{M} includes a resistor Rₘ and a resistance-control switch S_{Rm}. The resistance-control switch S_{Rm} is controlled by a control signal ctrl_R_m. The resistor-selecting unit RUₘ is formed by the resistor Rₘ connected to the resistance-control switch S_{Rm} in series. In other words, the control signals ctrl_R_1-ctrl_R_M may control the adjustable resistance module VR to adjust a resistance value between a first terminal NR₁ and a second terminal NR₂ of the adjustable resistance module VR, so as to change the integration gain of the integrating circuit 20 at different time intervals.

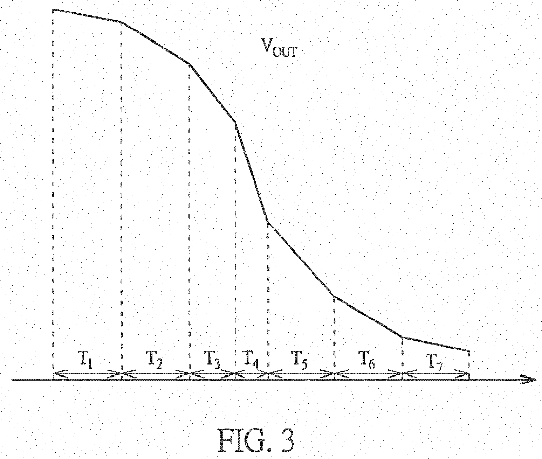

Operation of the integrating circuit 20 changing the integration gain at different time intervals may be referred to FIG. 3. FIG. 3 illustrates a waveform of an output signal V_{OUT} of the integrating circuit 20 when an input signal V_{IN} of the integrating circuit 20 is a DC (Direct Current) signal. As can be seen from FIG. 3, the resistance value between the first terminal NR₁ and the second terminal NR₂ of the adjustable resistance module VR may be adjusted with respect to time intervals T₁-T₇ by the control signals ctrl_R_1-ctrl_R_M, such that the integrating circuit 20 has different integration gains at the time intervals T₁-T₇. To realize the window function, preferably, the time intervals T₁, T₇ may have the smallest integration gain, the time intervals T₂, T₆ may have the second smallest integration gain, and the time interval T₄ at the center may have the largest integration gain.

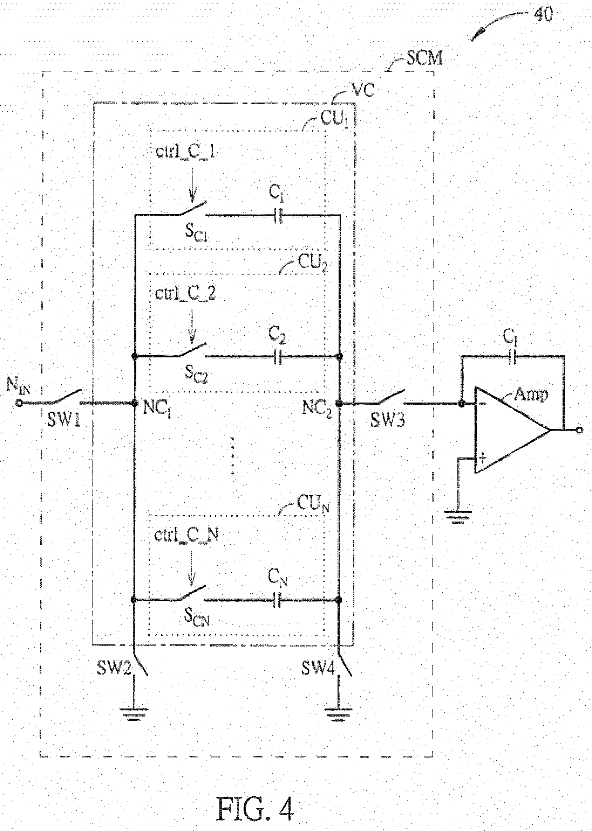

In addition, please refer to FIG. 4. FIG. 4 is a schematic diagram of an integrating circuit 40 according to an embodiment of the present invention. The integrating circuit 40 is similar to the integrating circuit 20, and thus, same components are denoted by the same symbols. Different from the integrating circuit 20, the integrating circuit 40 is a switched-capacitor integrator. The integrating circuit 40 includes a switched-capacitor module SCM. The switched-capacitor module SCM is coupled between the negative input terminal of the operational amplifier Amp and the integrating input terminal N_{IN} of the integrating circuit 40. The switched-capacitor module SCM includes an adjustable capacitance module VC and switches SW1-SW4. The switches SW1, SW2 are coupled to a first terminal NC₁ of the adjustable resistance module VC. The switches SW3, SW4 are coupled to a second terminal NC₂ of the adjustable resistance module VC. The switches SW2, SW4 are coupled to a ground. The adjustable capacitance module VC includes capacitor-selecting units CU₁-CU_{N}. The adjustable capacitance module VC is formed by the capacitor-selecting units CU₁-CU_{N} connected to each other in parallel, where any capacitor-selecting unit CUₙ within the capacitor-selecting units CU₁-CU_{N} includes a capacitor Cₙ and a capacitance-control switch S_{Cn}. The capacitance-control switch S_{Cn} is controlled by a control signal ctrl_C_n. The capacitor-selecting unit CUₙ is formed by the capacitor Cₙ connected to the capacitance-control switch S_{Cn} in series. In other words, the control signals ctrl_C_1-ctrl_C_N may be configured to control the adjustable capacitance module VC, to adjust a capacitance value between the first terminal NC₁ and the second terminal of the adjustable capacitance module VC at the different time intervals, so as to change integration gain of the integrating circuit 40 at different time intervals.

In addition, the switches SW1, SW2, SW3, SW4 may be controlled by frequency control signals ph1, ph2, where the frequency control signals ph1, ph2 are mutually orthogonal frequency control signals (i.e., time intervals of the frequency control signals ph1, ph2 being high voltage are not overlapped). Specifically, in an embodiment, the frequency control signal ph1 may be configured to control conduction status of the switches SW1, SW3, and the frequency control signal ph2 may be configured to control conduction status of the switches SW2, SW4. In another embodiment, the frequency control signal ph1 may be configured to control conduction status of the switches SW1, SW4, and the frequency control signal ph2 may be configured to control conduction status of the switches SW2, SW3. As long as the mutually orthogonal frequency control signals ph1, ph2 are utilized to control the conduction status of the switches SW1, SW2, SW3, SW4, requirements of present invention is satisfied, which is within the scope of present invention.

As can be seen, the integrating circuit 20 and the integrating circuit 40 utilize the adjustable resistance module VR and the adjustable capacitance module VC to adjust the resistance value of the adjustable resistance module VR and the capacitance value of the adjustable capacitance module VC at the different time intervals. In other words, the integrating circuit 20 and the integrating circuit 40 may change the integration gains of the integrating circuit 20 and the integrating circuit 40 at the different time intervals, so as to realize an effect of window function. Therefore, the integrating circuit 20 and the integrating circuit 40 may reduce noise brought by sidelobe, so as to enhance an overall SNR (Signal to Noise Ratio).

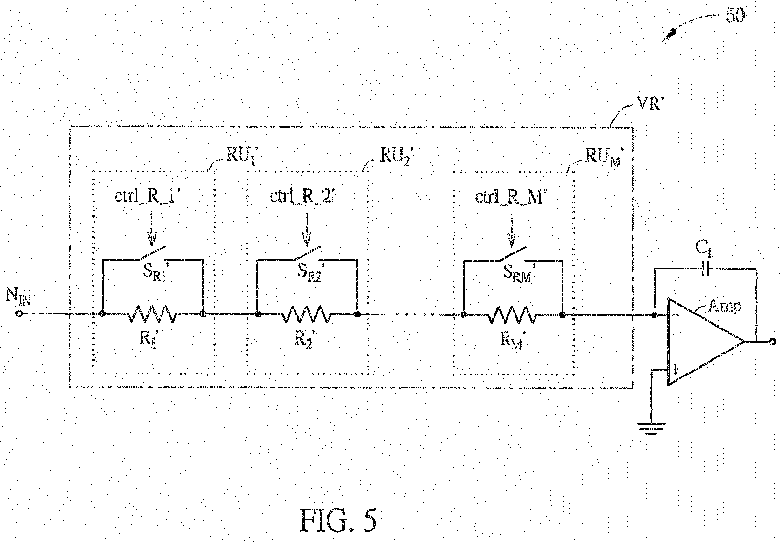

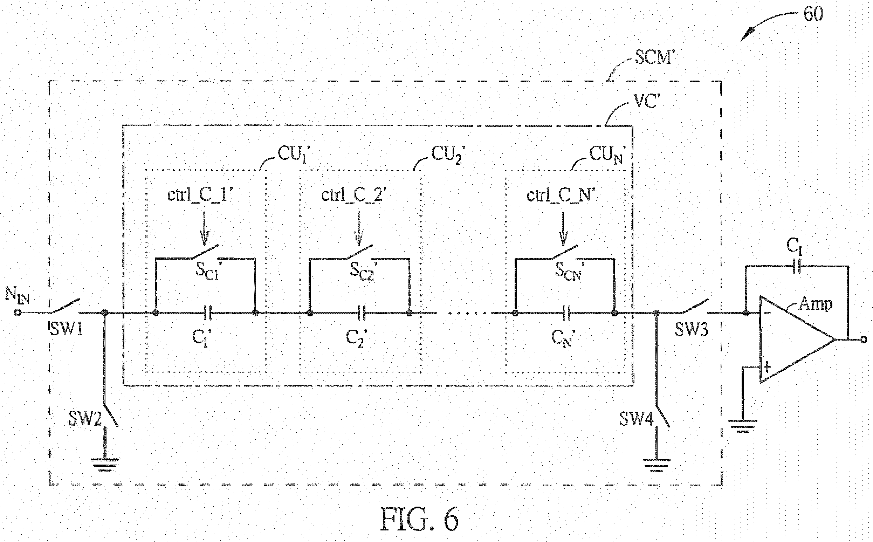

It should be noted that, the embodiments stated in the above are utilized for illustrating the concept of the present invention. Those skilled in the art may make modifications and alternations accordingly, and not limited herein. For example, in the adjustable resistance module VR, the resistor-selecting units RU₁-RU_{M} are connected to each other in parallel, and the resistor Rₘ is connected to the resistance-control switch S_{Rm} in series. In the adjustable capacitance module VC, the capacitor-selecting units CU₁-CU_{N} are connected to each other in parallel, and the capacitor Cₙ is connected to the capacitance-control switch S_{Cn}, which is not limited thereto. Please refer to FIG. 5. FIG. 5 is a schematic diagram of an integrating circuit 50 according to an embodiment of the present invention. The integrating circuit 50 is similar to the integrating circuit 20, and thus, same components are denoted by the same symbols. Different from the integrating circuit 20, the integrating circuit 50 includes an adjustable resistance module VR'. The adjustable resistance module VR' includes the resistor-selecting units RU₁'-RU_{M}'. The adjustable resistance module VR' is formed by the resistor-selecting units RU₁'-RU_{M}' connected to each other in series, wherein any resistor-selecting unit RUₘ' within the resistor-selecting units RU₁'-RU_{M}' includes a resistor Rₘ' and a resistance-control switch S_{Rm}'. The resistance-control switch S_{Rm}' is controlled by a control signal ctrl_R_m'. The resistor-selecting unit RUₘ' is formed by the resistor Rₘ' connected to the resistance-control switch S_{Rm}' in parallel. Similarly, please refer to FIG. 6. FIG. 6 is a schematic diagram of an integrating circuit 60 according to an embodiment of the present invention. The integrating circuit 60 is similar to the integrating circuit 20, and thus, same components are denoted by the same symbols. Different from the integrating circuit 20, the integrating circuit 60 includes a switched-capacitor module SCM'. The switched-capacitor module SCM' includes an adjustable capacitance module VC'. The adjustable capacitance module VC' includes the capacitor-selecting units CU₁'-CU_{N}'. The adjustable capacitance module VC' is formed by the capacitor-selecting units CU₁'-CU_{N}' connected to each other in series, wherein any capacitor-selecting unit CUₙ' within the capacitor-selecting units CU₁'-CU_{N}' includes a capacitor Cₙ' and a capacitance-control switch S_{Cn}'. The capacitance-control switch S_{Cn}' is controlled by a control signal ctrl_C_n'. The capacitor-selecting unit CUₙ' is formed by the capacitor Cₙ' connected to the capacitance-control switch S_{Cn}' in parallel.

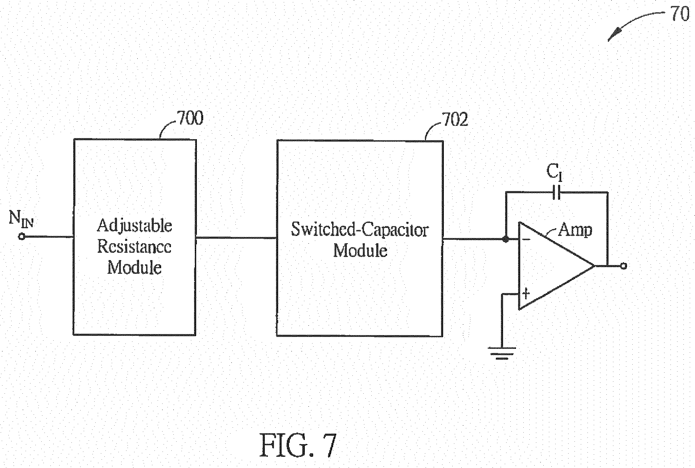

In addition, the integrating circuit may include the adjustable resistance module and the adjustable capacitance module at the same time. For example, please refer to FIG. 7. FIG. 7 is a schematic diagram of an integrating circuit 70 according to an embodiment of the present invention. The integrating circuit 70 is similar to the integrating circuit 20, and thus, same components are denoted by the same symbols. The integrating circuit 70 includes an adjustable resistance module 700 and a switched-capacitor module 702. The adjustable resistance module 700 and the switched-capacitor module 702 are both coupled between the negative input terminal of the operational amplifier Amp and the integrating input terminal N_{IN} of the integrating circuit 70, wherein the adjustable resistance module 700 may be realized by the adjustable resistance module VR or the adjustable resistance module VR', the switched-capacitor module 702 may be realized by the switched-capacitor module SCM or the switched-capacitor module SCM', which is not limited thereto.

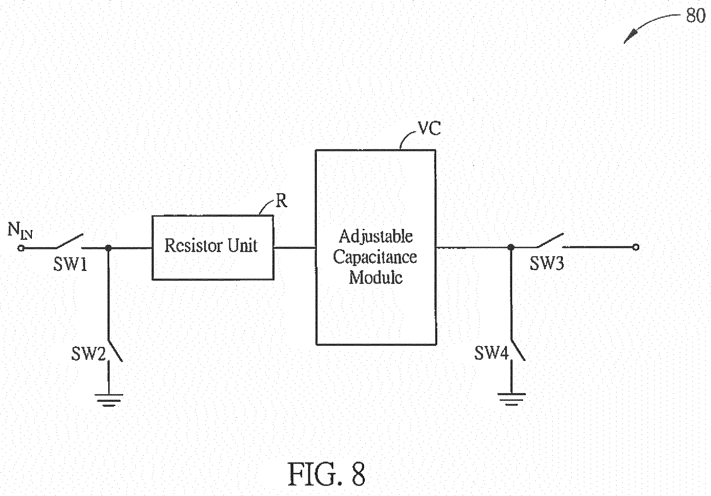

In addition, the switched-capacitor module is not limited to be realized by the switched-capacitor module SCM or the switched-capacitor module SCM' stated in the above. The switched-capacitor module may further include a resistor coupled between the switches SW1 and SW3. For example, please refer to FIG. 8. FIG. 8 is a schematic diagram of a switched-capacitor module 80 according to an embodiment of the present invention. Different from the switched-capacitor module SCM, SCM', the switched-capacitor module 80 further includes a resistor unit R coupled between the switches SW1 and SW3, where the resistor unit R may be one single resistor component or an adjustable resistance module , which is also within the scope of the present invention.

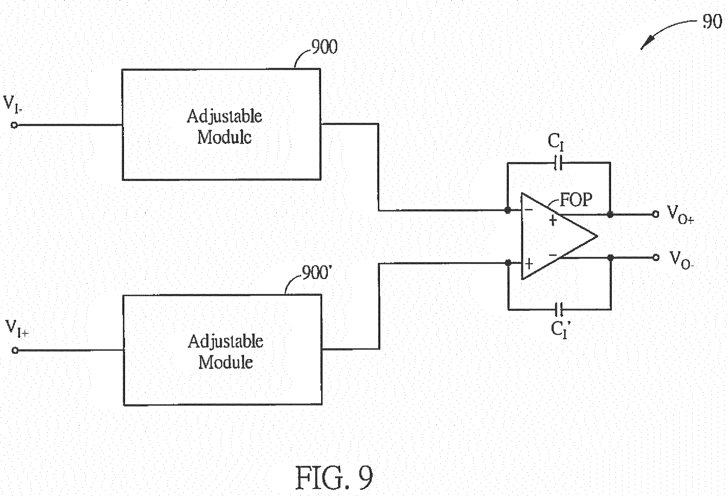

In addition, the adjustable resistance module or the switched-capacitor module stated in the above are applied in the integrating circuit with a single-ended input, which is not limited thereto. The adjustable resistance module or the switched-capacitor module may be applied in an integrating circuit with differential input. For example, please refer to FIG. 9. FIG. 9 is a schematic diagram of an integrating circuit 90 according to an embodiment of the present invention. The integrating circuit 90 receives differential input signals V_{I+}, V_{I-} and generates differential output signals V_{O+}, V_{O-}. The integrating circuit 90 includes a full differential operational amplifier FOP, the integrating capacitors C_{I} and C_{I}' and adjustable modules 900 and 900'. The adjustable module 900 and the adjustable module 900' may be realized by the adjustable resistance module VR, the adjustable resistance module VR', the switched-capacitor module SCM or the switched-capacitor module SCM'. In addition, the adjustable module 900 and the adjustable module 900' may also be realized by the adjustable resistance module VR (or the adjustable resistance module VR') connected to the switched-capacitor module SCM (or the switched-capacitor module SCM'), and not limited thereto. Preferably, the resistance values or the capacitance values of the adjustable module 900 and the adjustable module 900' may be controlled to be the same/consistent, so as to balance the differential signals, which is to improve the performance of the integrating circuit 90.

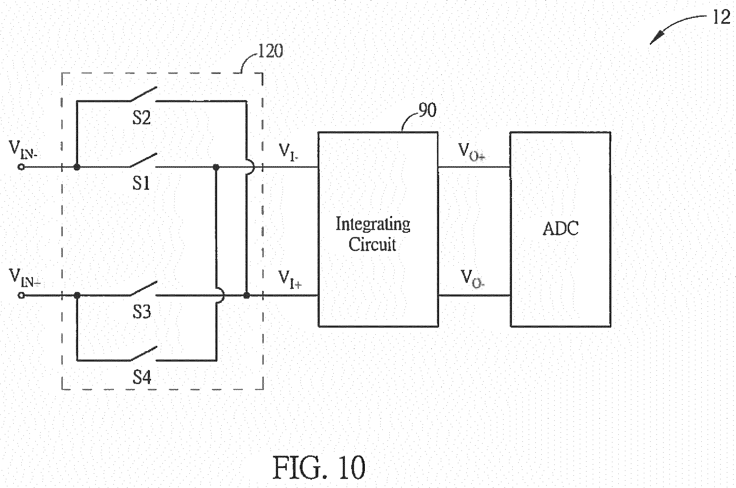

In addition, the integrating circuit 90 may be applied in a signal processing module. Please refer to FIG. 10. FIG. 10 is a schematic diagram of a signal processing module 12 according to an embodiment of the present invention. The signal processing module 12 includes a switching mixer 120, the integrating circuit 90 and an analog-to-digital converter ADC. The switching mixer 120 receives differential signals V_{IN+}, V_{IN-} and generates the differential input signals V_{I+}, V_{I-} to the integrating circuit 90. The analog-to-digital converter ADC receives the differential output signals V_{O+}, V_{O-} generated by the integrating circuit 90, and converts the analog differential output signals V_{O+}, V_{O-} into digital signals for the back-end circuit to perform further computing operations. The switching mixer 120 may include switches S1-S4. The switches S1, S2 are configured to receive the differential signal V_{IN-}. The switches S3, S4 are configured to receive the differential signal V_{IN+}. The switches S1, S4 are coupled to a first input terminal of the integrating circuit 90 to deliver the differential input signal V_{I-} to the integrating circuit 90. The switches S2, S3 are coupled to a second input terminal of the integrating circuit 90 to deliver the differential input signal V_{I+} to the integrating circuit 90.

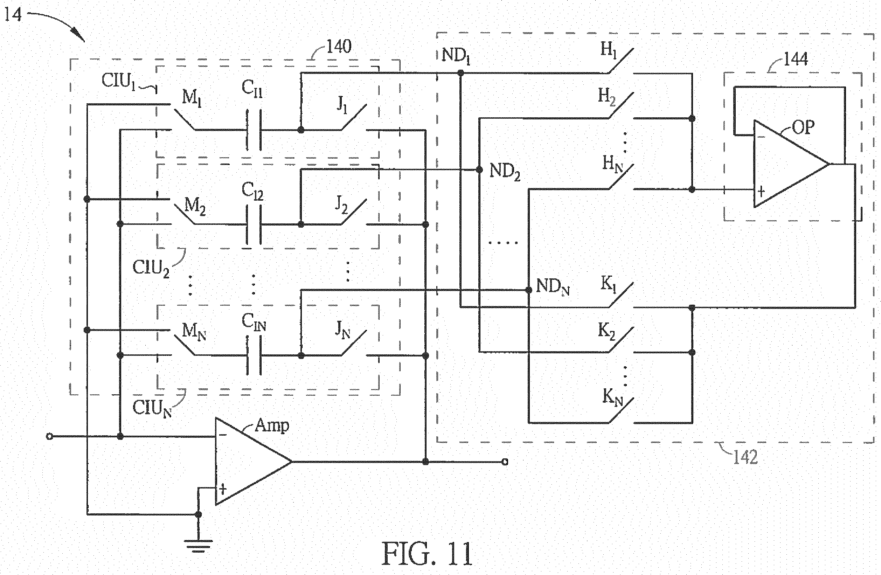

In addition, the integrating capacitor coupled between the input terminal and the output terminal of the operational amplifier Amp is realized by one single capacitor component, which is not limited thereto. The integrating capacitor coupled between the input terminal and the output terminal of the operational amplifier Amp may be realized by the adjustable capacitance module. Please refer to FIG. 11. FIG. 11 is a schematic diagram of an integrating circuit 14 according to an embodiment of the present invention. The integrating circuit 14 includes an adjustable integrating capacitor module 140, a voltage following module 142 and the operational amplifier Amp. The adjustable integrating capacitor module 140 is coupled between the positive and the negative input terminals and the output terminal of the operational amplifier Amp. The voltage following module 142 is coupled to the adjustable integrating capacitor module 140. Specifically, the adjustable integrating capacitor module 140 includes integrating-capacitor-selecting units CIU₁-CIU_{N}. The adjustable integrating capacitor module 140 is regarded as being formed by the integrating-capacitor-selecting units CU₁-CU_{N} connected to each other in parallel. Any integrating-capacitor-selecting unit CIUₙ within the integrating-capacitor-selecting units CIU₁-CIU_{N} includes an integrating capacitor C_{In} and the switches Mₙ, Jₙ. The integrating capacitor C_{In} and the switches Mₙ, Jₙ are connected in series. The integrating capacitor C_{In} is coupled to the positive and the negative input terminals of the operational amplifier Amp through the switch Mₙ. The integrating capacitor C_{In} is coupled to the output terminal of the operational amplifier Amp through the switch Jₙ.

In addition, the voltage following module 142 includes switches H₁-H_{N}, K₁-K_{N} and a voltage following circuit 144. The voltage following circuit 144 includes an operational amplifier OP. A negative input terminal (denoted as "-") of the operational amplifier OP is coupled to an output terminal of the operational amplifier OP. The output terminal of the operational amplifier OP is coupled to the switches K₁-K_{N}. A positive input terminal (denoted as "+") is coupled to the switches H₁-H_{N}. In addition, the voltage following module 142 includes nodes ND₁-ND_{N}. The switches H₁-H_{N} are coupled to the switches K₁-K_{N} at the nodes ND₁-ND_{N}, respectively. In other words, a terminal of any switch Hₙ within the switches H₁-H_{N} is coupled to the node NDₙ, and another terminal of the switch Hₙ is coupled to the positive input terminal of the operational amplifier OP. A terminal of any switch Kₙ within the switches K₁-K_{N} is coupled to the node NDₙ, and another terminal of the switch Kₙ is coupled to the output terminal of the operational amplifier OP. Each node NDₙ within the nodes ND₁-ND_{N} is coupled between the integrating capacitor C_{In} and the switch Jₙ. The switches M₁-M_{N}, J₁-J_{N}, H₁-H_{N}, K₁-K_{N} may receive and be controlled by a plurality of control signals (not illustrated in FIG. 11) to perform integration operation, and the plurality of control signals may change the integration gain of the integrating circuit 14 at different time intervals, to adjust a capacitance value between the negative input terminal and the output terminal of the operational amplifier Amp, so as to realize the effect of the window function.

Detail operations of the integrating circuit 14 are described as follows. When the integrating circuit 14 performs integration on an integrating capacitor C_{Ip} of the integrating capacitors C_{I1}-C_{IN}, the plurality of control signals controls the switches H₁-H_{N}, K₁-K_{N} to be cutoff. In addition, among the switches J₁-J_{N}, except a switch Jₚ corresponding to the integrating capacitor C_{Ip}. is conducted, the plurality of control signals control the rest switches J₁-Jₚ₋₁, Jₚ₊₁-J_{N} to be cutoff. In addition, the plurality of control signals control a switch Mp corresponding to the integrating capacitor C_{Ip-} among the switches M₁-M_{N} to conduct a connection between the integrating capacitor C_{Ip-} and the negative input terminal of the operational amplifier Amp. Except the switch Mp, the plurality of control signals control the rest switches M₁-Mₚ₋₁, Mₚ₊₁-M_{N} to conduct connections between the integrating capacitor and the positive terminal of the operational amplifier Amp. Before the integrating circuit 14 switches to perform integration on another integrating capacitor C_{Iq} of the integrating capacitors C_{I1}-C_{IN} from performing integration on the integrating capacitor C_{Ip}, the plurality of control signals control the switch Hp corresponding to the integrating capacitor C_{Ip} and the switch K_{q} corresponding to the integrating capacitor C_{Iq} to be closed (i.e., the switches Hₚ, Kq are conducted), and the rest switches H₁-Hₚ₋₁, Hₚ₊₁-H_{N}, K₁-K_{q-1}, K_{q+1}-K_{N} to be cutoff. Thus, the capacitance value between the negative input terminal and the output terminal of the operational amplifier Amp may be adjusted at the different time intervals, such that the integrating circuit 14 has different integration gains, so as to realize the effect of the window function.

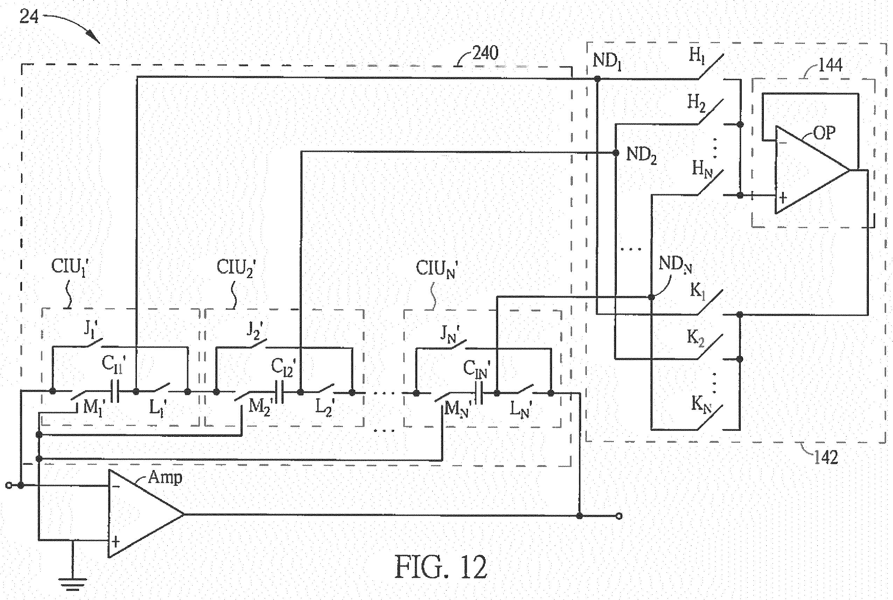

In addition, in the integrating circuit 14, the adjustable integrating capacitor module 140 is regarded as being formed by the integrating-capacitor-selecting units CIU₁-CIU_{N} connected to each other in parallel, which is not limited herein. Please refer to FIG. 12. FIG. 12 is a schematic diagram of an integrating circuit 24 according to an embodiment of the present invention. The integrating circuit 24 is similar to the integrating circuit 14, and thus, same components are denoted by the same symbols. Different from the integrating circuit 14, the integrating circuit 24 includes an adjustable integrating capacitor module 240. The adjustable integrating capacitor module 240 includes the integrating-capacitor-selecting units CIU₁'-CIU_{N}'. The adjustable integrating capacitor module 240 is formed by the integrating-capacitor-selecting units CIU₁'-CIU_{N}' connected to each other in series. Any integrating-capacitor-selecting unit CIUₙ' of the integrating-capacitor-selecting units CIU₁'-CIU_{N}' includes an integrating capacitor C_{In}' and switches Mₙ', Lₙ', Jₙ'. The integrating capacitor C_{In}' and the switches Mₙ', Lₙ' are connected in series. That is, the integrating capacitor C_{In}' and the switches Mₙ', Lₙ' are connected as a series, the switch Jₙ' is parallelly connected to the series formed by the integrating capacitor C_{In}' and the switches Mₙ', Lₙ'.

Detail operations of the integrating circuit 24 are described as follows. When the integrating circuit 24 performs integration on an integrating capacitor C_{Ip}' within the integrating capacitors C_{I1}'-C_{IN}', the switches H₁-H_{N}, K₁-K_{N} are cutoff. Within the switches J₁'-J_{N}', except the switch Jp' corresponding to the integrating capacitor C_{Ip}'- which is cutoff, the rest switches J₁'-Jₚ₋₁', Jₚ₊₁'-J_{N}' are conducted. In addition, the switch Lp' corresponding to the integrating capacitor C_{Ip}'. within the switches L₁'-L_{N}' are conducted. A switch Mₚ' corresponding to the integrating capacitor C_{Ip}.' within the switches M₁'-M_{N}' conducts a connection between the integrating capacitor C_{Ip-}' and the negative input terminal of the operational amplifier Amp. Before the integrating circuit 24 switches to perform integration on another integrating capacitor C_{Iq}' within the integrating capacitors C_{I1}'-C_{IN}' from performing integration on the integrating capacitor C_{Ip}', the switch Hp corresponding to the integrating capacitor C_{Ip}' and the switch K_{q} corresponding to the integrating capacitor C_{Iq}' are closed (i.e., the switches Hₚ, Kq are conducted), and the rest switches H₁-Hₚ₋₁, Hₚ₊₁-H_{N}, K₁-K_{q-1}, K_{q+1}-K_{N} are cutoff. In addition, a switch M_{q}' corresponding to the integrating capacitor C_{Iq}' within the switches M₁'-M_{N}' conducts a connection between the integrating capacitor C_{Iq-}' and the positive input terminal of the operational amplifier Amp. Thus, the capacitance value between the negative input terminal and the output terminal of the operational amplifier Amp may be adjusted at the different time intervals, such that the integrating circuit 14 has different integration gains to realize the effect of the window function.

Notably, the embodiments stated in the above are utilized for illustrating the best embodiments of the present invention, which is not limited thereto. For example, in FIG. 11, when the integrating capacitor C_{Iq} does not perform integration, the corresponding switch Mq is coupled to the positive input terminal of the operational amplifier Amp. In another embodiment (not illustrated), Mq may be coupled to any reference voltage, and the reference voltage does not have to be the same as the positive input terminal of the operational amplifier Amp, which also brings different integration gain for the integrating circuit 14 to realize the effect of the window function. Similarly, when there is no integration performed on the integrating capacitor corresponding to the switches M₁'-M_{N}', the switch may be coupled to any reference voltage, such that the integrating circuit 24 is utilized to realize the effect of the window function.

In summary, the present invention utilizes the adjustable resistance module or the adjustable capacitance module to change the integration gain of the integrating circuit at the different time intervals, so as to realize the window function, reduce noise brought by sidelobe and enhance the SNR. Compared to the prior art, the integrating circuit of the present invention may reduce a requirement of sampling rate of the analog-to-digital converter, such that the power consumption and complexity of the overall circuit are reduced.

The foregoing is only preferred embodiments of the present invention, it is not intended to limit the present invention, any modifications within the spirit and principles of the present invention made, equivalent replacement and improvement, etc., should be included in this within the scope of the invention.

## Claims

1. An integrating circuit, comprising:
an operational amplifier;
an integrating capacitor, coupled to an output terminal and a first input terminal of the operational amplifier; and
an adjustable resistance module, coupled between the first input terminal of the operational amplifier and an integrating input terminal of the integrating circuit, wherein the adjustable resistance module is configured to receive a plurality of first control signals, to adjust a resistance value of the adjustable resistance module.

2. The integrating circuit of claim 1, wherein the adjustable resistance module comprises a plurality of resistor-selecting units controlled by the plurality of first control signals respectively, and each resistor-selecting unit comprises:
a resistor; and
a resistance-control switch, coupled to the resistor.

3. The integrating circuit of claim 2, wherein the plurality of resistor-selecting units are connected to each other in parallel, and the resistor and the resistance-control switch of each resistor-selecting unit are connected to each other in series.

4. The integrating circuit of claim 2, wherein the plurality of resistor-selecting units are connected to each other in series, and the resistor and the resistance-control switch of each resistor-selecting unit are connected to each other in parallel.

5. The integrating circuit of claim 1, further comprising a switched-capacitor module, coupled between the first input terminal of the operational amplifier and the integrating input terminal of the integrating circuit, the switched-capacitor module comprises:
an adjustable capacitance module, configured to receive a plurality of second control signals, to adjust a capacitance value between a first terminal and a second terminal of the adjustable capacitance module;
a first switch, coupled to the first terminal of the adjustable capacitance module;
a second switch, coupled between the first terminal of the adjustable capacitance module and a ground;
a third switch, coupled between the second terminal of the adjustable capacitance module and the first input terminal of the operational amplifier; and
a fourth switch, coupled between the second terminal of the adjustable capacitance module and the ground.

6. The integrating circuit of claim 5, wherein the adjustable capacitance module comprises a plurality of capacitor-selecting units controlled by the plurality of second control signals respectively, to adjust the capacitance value of the adjustable capacitance module, and each capacitor-selecting unit comprises:
a capacitor; and
a capacitance-control switch, coupled to the capacitor.

7. The integrating circuit of claim 6, wherein the plurality of capacitor-selecting units are connected to each other in parallel, the capacitor and the capacitance-control switch of each capacitor-selecting unit are connected to each other in series; or wherein the plurality of capacitor-selecting units are connected to each other in series, the capacitor and the capacitance-control switch of each capacitor-selecting unit are connected to each other in parallel.

8. The integrating circuit of claim 5, wherein the switched-capacitor module further comprises:
at least a resistor unit, coupled between the first switch and the third switch.

9. An integrating circuit, comprising:
an operational amplifier;
an integrating capacitor, coupled to an output terminal and a first input terminal of the operational amplifier; and
a switched-capacitor module, coupled between the first input terminal of the operational amplifier and an integrating input terminal of the integrating circuit, the switched-capacitor module comprises:
an adjustable capacitance module, configured to receive a plurality of control signals, to adjust a capacitance value between a first terminal and a second terminal of the adjustable capacitance module;
a first switch, coupled to the first terminal of the adjustable capacitance module;
a second switch, coupled between the first terminal of the adjustable capacitance module and a ground;
a third switch, coupled between the second terminal of the adjustable capacitance module and the first input terminal of the operational amplifier; and
a fourth switch, coupled between the second terminal of the adjustable capacitance module and the ground.

10. The integrating circuit of claim 9, wherein the adjustable capacitance module comprises a plurality of capacitor-selecting units controlled by the plurality of control signals respectively, and each capacitor-selecting unit comprises:
a capacitor; and
a capacitance-control switch, coupled to the capacitor.

11. The integrating circuit of claim 10, wherein the plurality of capacitor-selecting units are connected to each other in parallel, the capacitor and the capacitance-control switch of each capacitor-selecting unit are connected to each other in series; or wherein the plurality of capacitor-selecting units are connected to each other in series, the capacitor and the capacitance-control switch of each capacitor-selecting unit are connected to each other in parallel.

12. The integrating circuit of claim 9, wherein the switched-capacitor module further comprises:
at least a resistor unit, coupled between the first switch and the third switch.

13. A signal processing module, comprising:
a switching mixer;
an analog-to-digital converter;
an integrating circuit, coupled between the switching mixer and the analog-to-digital converter, the integrating circuit comprises:
an operational amplifier;
an integrating capacitor unit, coupled to an output terminal and a first input terminal of the operational amplifier; and
an adjustable module, coupled between the first input terminal of the operational amplifier and an integrating input terminal of the integrating circuit, wherein the adjustable module is controlled by a plurality of signals, to adjust a resistance value or a capacitance value of the adjustable module.

14. The signal processing module of claim 13, wherein the adjustable module comprises an adjustable resistance module, and the adjustable resistance module is configured to receive a plurality of first control signals, to adjust the resistance value of the adjustable resistance module.

15. The signal processing module of claim 14, wherein the adjustable resistance module comprises a plurality of resistor-selecting units controlled by the plurality of first control signals respectively, and each resistor-selecting unit comprises:
a resistor; and
a resistance-control switch, coupled to the resistor.

16. The signal processing module of claim 15, wherein the plurality of resistor-selecting units are connected to each other in parallel, and the resistor and the resistance-control switch of each resistor-selecting unit are connected to each other in series signal; or wherein the plurality of resistor-selecting units are connected to each other in series, and the resistor and the resistance-control switch of each resistor-selecting unit are connected to each other in parallel.

17. The signal processing module of claim 13, wherein the adjustable module comprises a switched-capacitor module, coupled between the first input terminal of the operational amplifier and the integrating input terminal of the integrating circuit, and the switched-capacitor module comprises:
an adjustable capacitance module, configured to receive a plurality of second control signals, to adjust a capacitance value between a first terminal and a second terminal of the adjustable capacitance module;
a first switch, coupled to the first terminal;
a second switch, coupled between the first terminal and a ground;
a third switch, coupled between the second terminal and the first input terminal of the operational amplifier; and
a fourth switch, coupled between the second terminal and the ground.

18. The signal processing module of claim 17, wherein the adjustable capacitance module comprises a plurality of capacitor-selecting units controlled by the plurality of second control signals respectively, and each capacitor-selecting unit comprises:
a capacitor; and
a capacitance-control switch, coupled to the capacitor.

19. The signal processing module of claim 18, wherein the plurality of capacitor-selecting units are connected to each other in parallel, the capacitor and the capacitance-control switch of each capacitor-selecting unit are connected to each other in series signal; or wherein the plurality of capacitor-selecting units are connected to each other in series, the capacitor and the capacitance-control switch of each capacitor-selecting unit are connected to each other in parallel.

20. The signal processing module of claim 17, wherein the switched-capacitor module further comprises:
at least a resistor unit, coupled between the first switch and the third switch.

21. An integrating circuit, comprising:
a first operational amplifier;
an adjustable integrating capacitor module, coupled between a first input terminal and an output terminal of the first operational amplifier, wherein the adjustable integrating capacitor module comprises a plurality of integrating-capacitor-selecting units, and each integrating-capacitor-selecting unit comprises an integrating capacitor and at least a switch; and
a voltage following module, coupled to the plurality of integrating-capacitor-selecting units of the adjustable integrating capacitor module;
wherein the adjustable integrating capacitor module is configured to receive a plurality of control signals, to adjust a capacitance value between the first input terminal and the output terminal.

22. The integrating circuit of claim 21, wherein the voltage following module comprises a plurality of nodes, and the plurality of nodes are electrically connected to the integrating capacitors of the plurality of integrating-capacitor-selecting units, respectively.

23. The integrating circuit of claim 22, wherein the voltage following module comprises a voltage following circuit, and each node of the plurality of nodes is coupled to an input terminal of the voltage following circuit through a first switch and coupled to an output terminal of the voltage following circuit through a second switch.

24. The integrating circuit of claim 23, wherein the voltage following circuit comprises a second operational amplifier, wherein a first input terminal of the second operational amplifier is electrically connected to an output terminal of the second operational amplifier, a second input terminal of the operational amplifier is the input terminal of the voltage following circuit, and an output terminal of the operational amplifier is the output terminal of the voltage following circuit.

25. The integrating circuit of claim 21, wherein the plurality of integrating-capacitor-selecting units are connected to each other in parallel.

26. The integrating circuit of claim 21, wherein the plurality of integrating-capacitor-selecting units are coupled to each other in series.
